# EUROPEAN PATENT APPLICATION

(11) **EP 4 739 079 A1**
(43) Date of publication of application: **06.05.2026**
(21) Application number: 25208586.5
(22) Date of filing: 14.10.2025
(51) Int. Cl.: H10W 72/90, H10W 72/00, H10W 72/59

(54) **METHOD FOR IMPROVING ADHESION OF A WETTABLE METALLIZATION MULTILAYER IN AN INTEGRATED ELECTRONIC DEVICE**

(30) Priority: 29.10.2024 IT 202400024102
(71) Applicant: STMicroelectronics International N.V., 1228 Plan-les-Ouates, Geneva (CH)
(72) Inventor: CAFRA, Brunella, 20864 AGRATE BRIANZA (MB) (IT); LANDI, Antonio, 20864 AGRATE BRIANZA (MB) (IT); RENNA, Crocifisso Marco Antonio, 20864 AGRATE BRIANZA (MB) (IT)
(74) Representative: Studio Torta S.p.A.

(57) **Abstract**

A process for forming silver-containing wettable material structures, wherein, on a metal layer (26) containing aluminum, a zinc layer (28) is deposited, the zinc layer reacting with the metal layer and creating a surface microroughness (30); the zinc layer (28) is removed; and a wettable layer (36) containing silver is deposited by vapor deposition. The wettable layer (36) is formed by an adhesion layer (33), containing titanium or chromium; a barrier layer (34), containing nickel, on the adhesion layer (33); and a bonding layer (35), containing silver, on the barrier layer (22).

## Description

### Technical Field

The present invention relates to a method for improving adhesion of a wettable metallization multilayer in an integrated electronic device.

### Background

As is known, integrated electronic devices are connected to the outside through connection regions, for example pads, of highly conductive material, typically metal. Connection regions allow sintering of electrical connectors, such as wires, ribbons or clips, which electrically couple active and passive regions of the integrated electronic device to the outside, e.g. with conductive tracks formed on or in a printed circuit board or other support.

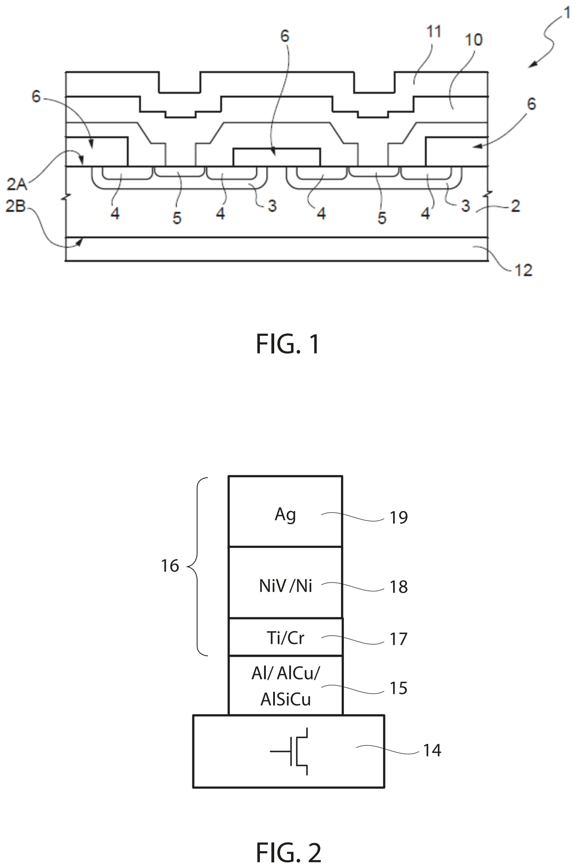

For example, Figure 1 shows an integrated electronic device 1 having a top metallization including a wettable layer.

In particular, the integrated electronic device 1 of Figure 1 is a MOSFET transistor formed in a substrate 2, of semiconductor material (e.g. silicon) and of a first conductivity type, for example of N-type, having a front surface 2A and a back surface 2B. The substrate 2 accommodates body regions 3.

In turn, the body regions 3, of a second conductivity type opposite to the first conductivity type, in the example of P-type, accommodate source regions 4, of the first conductivity type, and body contact regions 5, of the second conductivity type and dopant concentration greater than the body regions 3. Insulated gate regions 6 extend above the front surface 2A of the substrate 2, astride two adjacent body regions 3.

A source metalization layer 10 covers the front surface 2A of the substrate 2, where exposed, and the insulated gate regions 6. A wettable layer 11 covers the source metalization layer 10.

The source metalization layer 10 is formed by a plurality of layers, such as titanium Ti and a copper-based alloy (for example AlSiCu), and the wettable layer 11 comprises silver Ag, as discussed below.

The back surface 2B of the substrate 2 is covered by a drain metalization 12, for example formed by a plurality of layers including titanium Ti, nickel-vanadium NiV or nickel Ni and silver Ag.

The MOSFET transistor shown in Figure 1 is only one example of integrated electronic device to which the present disclosure relates. For example, the integrated electronic device 1 might be a High Electron Mobility Transistor (HEMT) or other device formed on a silicon (Si), silicon carbide (SiC), or gallium nitride (GaN) substrate.

Currently, for forming the contact regions arranged on the front side of electronic devices and comprising a wettable layer similar to the wettable layer 11 of Figure 1, stacks of different metals are used, which ensure good adhesion both to the surface of the integrated device and to the wires, ribbons and connection clips (electrical connectors; hereinafter, for the sake of simplicity, reference will be made to wires, meaning by this term also flatter structures, such as ribbons, clips and the like).

For example, a stack of metal layers, currently widely used for forming the wettable layer 11, comprises three-four layers, as shown in Figure 2.

Figure 2 shows a device 14, including for example an integrated transistor, as schematically represented, formed by the substrate 2, regions and layers integrated into the substrate 2 and/or extending above the substrate 2.

The device 14 is overlaid by a metallization layer 15, for example the source metallization layer 10 of Figure 1.

The metallization layer 15 is typically formed of pure aluminum or an alloy of aluminum and copper or an alloy of aluminum, silicon, copper (wherein aluminum is the main component).

The metallization layer 15 is overlaid by a wettable layer 16 (corresponding to the wettable layer 11 of Figure 1) formed by a stack of layers deposited by PVD (Physical Vapor Deposition).

For example, Figure 2 shows a wettable layer 16 including a first layer 17, for example of titanium Ti or chromium Cr; a second layer 18, for example of a nickel-vanadium alloy NiV or of nickel Ni alone, and a third layer 19, of silver Ag.

In some cases, an additional layer of nickel Ni may be provided between the second layer 18 and the third layer 19 and/or a chromium layer may be arranged between the metallization layer 15 and the first layer 17, when made of nickel.

Furthermore, according to Italian patent application 102023000021621 filed on 17 October 2023, the third layer 19 (and possibly the second layer 18) may contain aluminum or tin atoms, and/or an intermetal layer containing aluminum or tin atoms may extend between the second layer 18 and the third layer 19.

The first layer 17 has the function of ensuring good adhesion of the wettable layer 16 with the metallization layer 15 and is also referred to as "adhesion layer"; the third layer 19 has the function of allowing a good bonding process between the third layer 19, of silver, and a wire or other external electrical connector and is also referred to as "bonding layer"; and the second layer 18 has a diffusive barrier function between the first layer 17 and the third layer 19 and is also referred to as "barrier layer".

However, in the case of a stack of layers with a third layer 19 of silver, in some cases insufficient adhesion occurred with the nickel-vanadium alloy or the underlying nickel layer. In particular, in such cases, during the wire bonding step, the third layer 19 of silver lifted completely, exposing the underlying second layer 18 of NiV/Ni.

Currently, various approaches have been attempted to limit the indicated detachment phenomenon, including better control of the environment to reduce the presence of oxygen; an improvement of the topography and, in particular, of the planarity of the device surface (and consequently of the silver layer) and the increase in thickness of the silver layer, but none of them has been decisive.

US 2014/001636A1 and US 2016/181224A1 disclose electronic devices comprising a die having a contact structure including a metal layer containing aluminum and a metal layer containing silver.

The aim of the present invention is to provide a solution that allows manufacturing a wettable stack of layers containing Ag and NiV or Ni that does not have the delamination and detachment problem described above.

### Summary

According to the present invention, a process for forming silver-containing wettable material structures and an electronic device are provided, as defined in the appended claims.

### Brief Description of the Drawings

For a better understanding of the present invention, an embodiment thereof is now described, purely by way of nonlimiting example, with reference to the attached drawings, wherein:
- Figure 1 shows a cross-section of a power MOSFET device having an external-connection wettable layer;
- Figure 2 shows a cross-section of a stack of layers including a wettable layer of an integrated electronic device, on an enlarged scale;
- Figures 3A-3D are cross-sections during successive manufacturing steps of a stack of wettable material, wherein Figure 3D is on an enlarged scale with respect to Figures 3A-3C;
- Figure 4 is a flow chart of an embodiment of a manufacturing process of a stack of wettable material;
- Figure 5A is a 3D image taken with a Transmission Electron Microscopy (TEM) on a layer of the stack of Figure 3D;
- Figure 5B is a cross-sectional image of a part of the stack of Figure 3D, taken through a Transmission Electron Microscopy (TEM);
- Figure 6 shows an electronic device having a contact structure formed with the stack of Figure 53D.

### Description of Embodiments

The following description refers to the arrangement shown; consequently, expressions such as "above", "below", "upper", "lower", "right", "left" relate to the attached Figures and are not to be interpreted in a limiting manner.

The present disclosure relates to a method that allows an increase of the adhesion of a wettable metallization multilayer to an underlying layer, increasing the roughness of the metal layer, such as the metallization layer 15 of Figure 2, using a surface zincation of the metal layer, which causes a corrosion of its surface; removal of the obtained zinc layer, which increases the obtained roughness; and a PVD deposition of the wettable layer. By virtue of this process, the adhesion between the wettable layer and the underlying layer is ensured.

In particular, this process allows to increase an average roughness Ra of about 8 nm to an average roughness of 20-30 nm. Furthermore, the obtained roughness is uniform throughout the surface of the metal layer, which is very important in semiconductor manufacturing processes, to obtain batches of devices with uniform chemical-physical characteristics, and therefore uniform electrical performances.

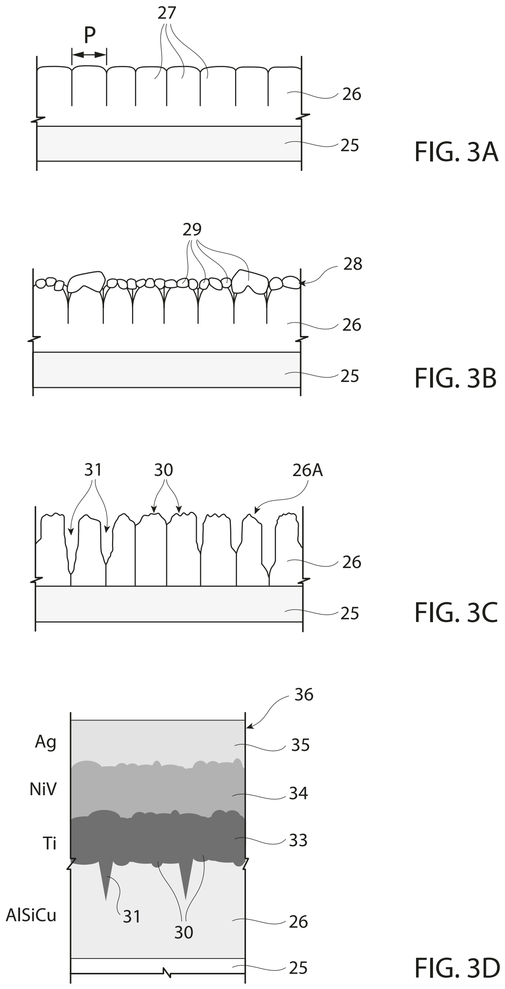

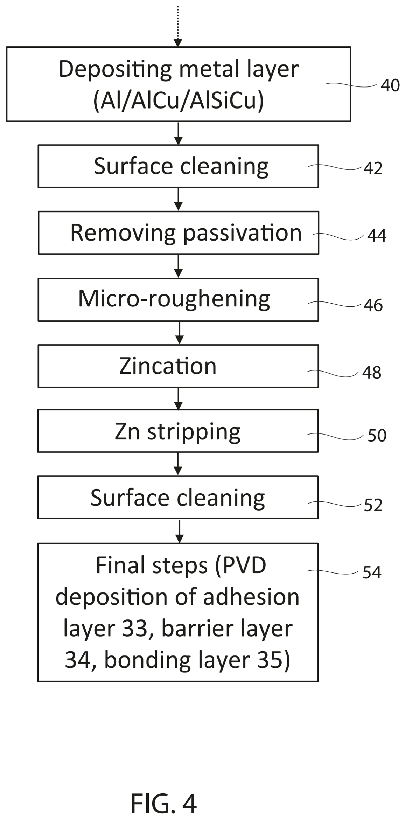

With reference to Figures 3A-4D and 4, a treatment process to obtain the desired roughness will now be described.

With reference to Figure 3A, a metal layer 26 containing aluminum, for example of Al, AlCu and AlSiCu, is deposited on a substrate 25, for example a wafer of semiconductor material integrating conductive regions and insulating regions (not shown), a glass sheet or other starting support, step 40 of Figure 4.

The thickness of the metal layer 26 depends on the specific application; it has an intrinsic roughness, for example corresponding to the pitch P between the aluminum grains, of about 200 nm.

Then, step 42 of Figure 4, the surface of the metal layer 26 is cleaned using, for example, organic solvents.

In step 44 of Figure 4, passivation residues of alumina (native aluminum oxide) are removed from the surface of the metal layer 26, e.g. through wet etching using liquids that are commercially available to this end.

This step may be omitted if the metal layer 26 does not have passivation residues of alumina, e.g. due to previous treatments and/or storage conditions.

In step 46 of Figure 4, the metal layer 26 is etched using strongly acidic or strongly basic compounds to increase the roughness.

In this manner, as shown in Figure 3A, the roughness, also linked to the size of the aluminum grains 27 forming the metal layer 26, may lead to have indentations between the grains.

A possible washing follows.

In step 48 of Figure 4, a zincation process is performed. For example, the zincation process may occur by immersing the structure comprising the substrate 25 and the metal layer 26 in a bath containing zinc, commercially available for performing zincation in different device zones.

For example, the bath may comprise a solution of zinc oxide (50 kg/m³) and sodium hydroxide (250 kg/m3).

Zincation may occur without an electro-less (e-less), process.

A zinc layer, indicated by 28 in Figure 3B, is thus formed. The zinc layer 28 is typically thin, for example 0.1-0.3 µm, although this value is not critical.

As is known, the deposited zinc, which is deposited in polycrystalline form (represented in Figure 3B by grains 29), etches the underlying aluminum grains 27, partially dissolving them, based on the crystallographic planes thereof, and causing an increase in the roughness of the metal layer 26, as shown in Figure 3B.

This step may last 15-45 seconds or more, for example about 30 seconds.

In step 50 of Figure 4, the zinc layer 28 is removed. Removal may occur by stripping, by washing with a suitable, commercially available solution for removing and selectively removing zinc layers.

The steps 48 and 50 in Figure 4 may be repeated two or more times, if necessary.

At the end of the (possibly repeated) zincation step, the metal layer 26 has a high micro-roughness 30, as visible in Figure 3C, which shows the structure formed by the substrate 25 and the metal layer 26 after stripping. As is noted, on the top surface of the metal layer 26, indicated by 26A, the micro-roughness 30 is due to the presence of irregularities with dimensions comprised between 20 and 30 nm (Ra = 20-30 nm).

In particular, the micro-roughness 30 on the top surface 26A of the metal layer 26 is added to the presence of grooves 31, due to the grains of the metal layer 26.

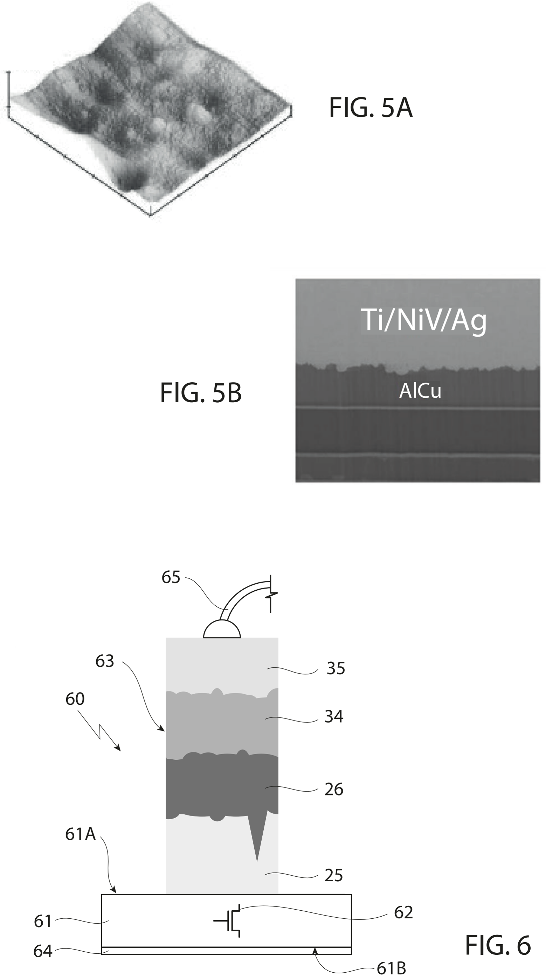

The micro-roughness 30 is also evident in Figures 5A and 5B which show images obtained with an electron microscopy of the top surface 26A of the metal layer 26.

At the end of the zincation and stripping step(s) 48, 50, zinc layer 28 is completely removed.

Subsequently, cleaning of the surface 26A of the metal layer is performed, step 52.

Then, step 54 of Figure 4, the process proceeds with final steps for growing the wettable layer.

For example, see Figure 3D, step 54 includes:
depositing, through PVD, an adhesion layer 33, for example of titanium Ti or chromium Cr;
depositing, through PVD, a barrier layer 34, for example of a nickel-vanadium alloy NiV or nickel Ni alone; and
depositing, through PVD, a silver - Ag - containing layer 35 (bonding layer). For example, the silver layer may be a pure silver - Ag - layer.

PVD deposition may done by sputtering.

A stack 36 of wettable multilayer material is thus formed.

Final steps then follow for manufacturing an integrated device.

As is noted, in Figure 3D, the high micro-roughness 30 of the metal layer 26 at the end of the zincation is also maintained on the top layers 33-35 of the stack 36.

Furthermore, the final steps typically also comprise definition of the stack 36, by known photolithographic and etching processes.

Alternatively, and depending on the device to be manufactured, the layers of the stack 36 may be defined separately, possibly using suitable masks.

In this manner, an electronic device 60, schematically shown in Figure 6 and comprising a die 61 integrating for example a transistor 62, represented schematically, may be provided. The die 61 has a top surface 61A, with a contact structure 63 thereon obtained by defining the stack 36, after its definition, and a bottom surface 61B, having a metallization layer 64 thereon.

The stack 36 may therefore be used for bonding wires 65, as shown schematically in Figure 6, or other connection structures.

The wettable layer (stack 36) on the surface 26A of the metal layer 26 containing aluminum has improved adhesion by virtue of the mechanical anchoring due to the micro-roughness 30, avoiding the detachment of the silver layer (bonding layer 35) during the bonding step of the wires 65.

The process does not damage the active layers of the device, unlike current zincation processes performed on the back, which use sulfuric acid.

It is also well integrable with currently used process flows and therefore has high reliability, without increasing manufacturing costs.

Finally, it is clear that modifications and variations may be made to the process and device described and illustrated here without thereby departing from the scope of the present invention, as defined in the attached claims.

## Claims

1. A process for forming silver-containing wettable material structures, comprising:
forming a metal layer (26) containing aluminum;
depositing a zinc layer (28) on the metal layer (26), the zinc layer reacting with the metal layer and creating a surface micro-roughness (30);
removing the zinc layer (28); and
depositing a wettable layer (36) containing silver by vapor deposition.

2. The process according to claim 1, wherein depositing a wettable layer (36) comprises:
forming an adhesion layer (33), containing titanium or chromium, on a front side (26A) of the metal layer (26);
forming a barrier layer (34), containing nickel, on the adhesion layer (33); and
forming a bonding layer (35), containing silver, on the barrier layer (22).

3. The process according to claim 1 or 2, wherein the metal layer (26) is of pure aluminum or an alloy of aluminum and copper or an alloy of aluminum, silicon, copper.

4. The process according to any of the preceding claims, wherein the barrier layer (34) is of nickel or a nickel-vanadium alloy.

5. The process according to any of the preceding claims, wherein depositing a zinc layer (28) and removing the zinc layer (28) are repeated.

6. The process according to any of the preceding claims, wherein removing the zinc layer (28) is performed by stripping.

7. The process according to any of the preceding claims, further comprising, after forming a metal layer (26), etching a surface (26A) of the metal layer using strongly acidic or strongly basic compounds.

8. The process according to any of the preceding claims, further comprising defining the wettable layer (36) to form a contact structure on a top side (61A) of a wafer (61) of semiconductor material.

9. The process according to any of the preceding claims, wherein depositing a wettable layer (36) is performed by sputtering.

10. An electronic device (60) comprising:
a die (61) of semiconductor material having a front surface (61A) and a back surface (61B);
a wettable contact structure (63) extending on the front surface (61A) and including:
a metal layer (26) containing aluminum, the metal layer having a surface micro-roughness (30), with irregularities having dimensions comprised between 20 and 30 nm; and
a wettable layer (36) containing silver, deposited by PVD; and
a back contact metallization (64), extending on the back surface (61B) of the die (61).

11. The device according to the preceding claim, wherein the wettable layer (36) comprises:
an adhesion layer (33), containing titanium or chromium, on a front side (26A) of the metal layer (26);
a barrier layer (34), containing nickel, on the adhesion layer (33); and
a bonding layer (35), containing silver, on the barrier layer (34).

12. The device according to claim 10 or 11, wherein the metal layer (26) is of pure aluminum or an alloy of aluminum and copper or an alloy of aluminum, silicon, copper.

13. The device according to any of claims 10-12, wherein the barrier layer (34) is of nickel or a nickel-vanadium alloy.

14. The device according to any of claims 10-13, wherein the surface micro-roughness (30) has a Ra comprised between 20 and 30 nm.
